# EUROPEAN PATENT SPECIFICATION

(11) **EP 4 003 577 B1**
(45) Date of publication and mention of the grant of the patent: **20.08.2025**
(21) Application number: 20747160.8
(22) Date of filing: 24.07.2020
(51) Int. Cl.: B01D 65/10, H04R 17/02, H04R 29/00, H10N 30/30, H02N 2/18

(54) **SELF POWERED MODULE INTEGRITY INDICATOR USING A PIEZOELECTRIC SENSOR**
INTEGRITÄTSINDIKATOR EINES SELBSTGESPEISTEN MODULS UNTER VERWENDUNG EINES PIEZOELEKTRISCHEN SENSORS
INDICATEUR D'INTÉGRITÉ DE MODULE AUTO-ALIMENTÉ UTILISANT UN CAPTEUR PIÉZOÉLECTRIQUE

(30) Priority: 26.07.2019 US 201962879158 P
(43) Date of publication of application: 01.06.2022
(73) Proprietor: DuPont Specialty Materials Singapore Pte. Ltd., Singapore 018983 (SG)
(72) Inventor: TEO, Yinghao, Windsor, New South Wales 2756 (AU)
(74) Representative: Houghton, Mark Phillip
(86) International application number: PCT/SG2020/050428
(87) International publication number: WO 2021/021018

(56) References cited:
- CN-U- 201 502 985
- FR-A1- 2 909 904
- KR-B1- 101 023 792
- KR-B1- 101 753 453
- T. H. NG ET AL: "Sensitivity Analysis and Energy Harvesting for a Self-Powered Piezoelectric Sensor", JOURNAL OF INTELLIGENT MATERIAL SYSTEMS AND STRUCTURES., vol. 16, no. 10, 1 October 2005 (2005-10-01), US, pages 785 - 797, XP055731297, ISSN: 1045-389X, DOI: 10.1177/1045389X05053151

## Description

### Background

Hollow fiber or other membrane water treatment apparatus utilize methods to determine whether the fiber or membrane is integral or free of defects. These methods may include a bubble point test where air is used to force water out of the membrane pores. The air pressure required can be correlated to the pore size. Another method is the pressure decay test.

CN 201 502 985 U discloses a lighting device adopting insulated piezoelectric oscillator to drive lightemitting diode. KR 101 023 792 B1, KR 101 753 453 B1 and FR 2 909 904 A1 disclose membrane integrity testing systems.

### Pressure Decay Test (PDT)

Pressure decay tests (or pressure holding tests) are the most common test methodology used in the field, which are performed *in situ* at below the bubble point by reversing the permeate flow with pressurized air. Once all the water filled in membrane lumen permeates back through the membrane, membrane lumen is filled up with pressurized air. Due to capillary suction pressure, air does not leak through the membrane as long as pressure is below the bubble point. After isolating the membrane from a pressure source, the lumen pressure is monitored for a predetermined time (5-20min typical). If there are defects on the membrane surface, air can permeate through the defects and the pressure drops quickly. If there are no defects, only a small amount of air will be lost by the diffusion through the membrane pores.

However, it is not perfectly clear where to set a line between normal pressure decay rate and abnormal pressure decay rate.

Pressure decay tests are particularly useful for the hollow fiber membranes with an integrated skin with support layer. It can be also used for the hollow fiber membranes with nonintegrated skin layer and flat sheet membranes, but the maximum allowable air pressure may not be high enough to detect the breaches smaller than, for example, 3-5 micron.

A variation of the pressure decay test involves the use of a microphone or noise sensor that is utilized to detect escaping air from a defective fiber. The current way for module integrity checkis to use a sonic analyzer, i.e. microphone, to 'listen' and grade the noise level within a module. However, using a microphone requires a power source which might not be readily available.

In one embodiment, Piezoelectric elements could generate electricity from deformation or vibration, and vice versa. These circuits are well known.

This circuit could be made into a box, presumably less than 50mm x 50mm x 10mm or smaller and attached to the housing of a pressurized hollow fiber module. When a PDT is conducted and a module is not integral, i.e. leaky fibers are present, a lot of noise (vibration) will be generated. This vibration will then be converted to an electrical signal which in turn can be used to power a visual signal such as a light emitting diode (LED).

The proposed way is to provide a visual indicator (via changes in brightness or colors) that is linked to the noise level. The amount of electrical power generated will be proportional to the amount of noise emitting from each module. Thus, the LED indicator can change color or intensity depending on the noise level from a module. This will provide a visual indication on the relative integrity of each module. A greater amount of noise will in turn mean a greater voltage is generated and thus the LED will be illuminated more brightly compared with a low noise output from a module.

The entire piezoelectric assembly may be fabricated onto a circuit board or even an integrated circuit which would become even smaller in size, and lower cost when mass produced.

The main advantage for the proposed indicator will be a time saving for the customer during troubleshooting. The relative noise levels of each module could be viewed from a distance, as compared to the sonic analyzer method which requires physical access to each module.

## Claims

1. A system to monitor the integrity of a pressurized hollow fiber membrane module, the system comprising; a pressurized hollow fiber membrane module in a housing; and a piezoelectric sensor attached to the housing; wherein the piezoelectric sensor is capable of generating a voltage when exposed to vibrations from the pressurized hollow fiber membrane module and; a visual indicator comprising a light emitting diode electrically connected to the piezoelectric sensor; wherein the visual indicator provides a visual indication proportional to the intensity of vibrations from the pressurized hollow fiber membrane module.

## Patentansprüche

1. System zum Überwachen der Unversehrtheit eines unter Druck stehenden Hohlfasermembranmoduls, wobei das System umfasst: ein unter Druck stehendes Hohlfasermembranmodul in einem Gehäuse; und einen piezoelektrischen Sensor, der an dem Gehäuse angebracht ist; wobei der piezoelektrische Sensor in der Lage ist, eine Spannung zu erzeugen, wenn er Schwingungen von dem unter Druck stehenden Hohlfasermembranmodul ausgesetzt ist; und einen visuellen Indikator, der eine lichtemittierende Diode umfasst, die elektrisch mit dem piezoelektrischen Sensor verbunden ist; wobei der visuelle Indikator eine visuelle Angabe bereitstellt, die proportional zu der Intensität von Schwingungen von dem unter Druck stehenden Hohlfasermembranmodul ist.

## Revendications

1. Système de surveillance de l'intégrité d'un module de membrane à fibres creuses pressurisé, le système comprenant : un module de membrane à fibres creuses pressurisé dans un boîtier ; et un capteur piézoélectrique fixé au boîtier ; le capteur piézoélectrique étant capable de générer une tension lorsqu'il est exposé aux vibrations du module de membrane à fibres creuses pressurisé ; et un indicateur visuel comprenant une diode électroluminescente connectée électriquement au capteur piézoélectrique ; dans lequel l'indicateur visuel fournit une indication visuelle proportionnelle à l'intensité de vibrations du module de membrane à fibres creuses pressurisé.
